# EUROPÄISCHE PATENTSCHRIFT

(11) **EP 0 391 200 B1**
(45) Veröffentlichungstag und Bekanntmachung des Hinweises auf die Patenterteilung: **11.10.1995**
(21) Anmeldenummer: 90105739.8
(22) Anmeldetag: 26.03.1990
(51) Int. Cl.: G03F 7/038, G03F 7/039

(54) **Herstellung hochwärmebeständiger Reliefstrukturen**
Formation of very heat-stable relief patterns
Fabrication de structures en relief très stables à la chaleur

(30) Priorität: 06.04.1989 DE 3911212
(43) Veröffentlichungstag der Anmeldung: 10.10.1990
(73) Patentinhaber: SIEMENS AKTIENGESELLSCHAFT, 80333 München (DE)
(72) Erfinder: Ahne, Hellmut, Dr., D-8551 Röttenbach (DE); Hammerschmidt, Albert, Dr., D-8520 Erlangen (DE); Schmidt, Erwin, D-8520 Erlangen (DE)

(56) Entgegenhaltungen:
- EP-A- 0 041 677
- EP-A- 0 291 779
- DE-A- 3 716 629

## Beschreibung

Die Erfindung betrifft ein Verfahren zur Herstellung hochwärmebeständiger Reliefstrukturen aus oligomeren und/oder polymeren Polybenzoxazol-Vorstufen.

Lösliche Polybenzoxazol-Vorstufen dienen als Harzbasis in wärmebeständigen Photoresists zur Herstellung hochwärmebeständiger Reliefstrukturen, d.h. zur kostengünstigen direkten Strukturierung organischer Isolierschichten. Die aus den Vorstufen erhaltenen Polybenzoxazole zeichnen sich durch hohe Temperaturbeständigkeit, geringe Wasseraufnahme und hervorragende elektrische Eigenschaften aus (siehe dazu EP-OS 0 291 778); sie eignen sich deshalb als organische Dielektrika in der Halbleiterfertigung sowie als Ätzmasken, insbesondere bei alkalischen Ätzprozessen.

Photoresists auf der Basis von Polybenzoxazol-Vorstufen können mittels konventioneller Belichtungsapparaturen (Kontaktbelichtung oder Projektionsbelichtung) photostrukturiert werden. Hierbei ist es aber erforderlich, daß der Photoresist lichtempfindliche Gruppen aufweist bzw. der Photolack eine photoaktive Komponente enthält. Photostrukturierbare Polybenzoxazol-Vorstufen mit vernetzbaren ungesättigten Gruppen, die als Negativresist dienen, sind beispielsweise aus der EP-PS 0 041 677 bekannt. Positivresists auf der Basis von Polybenzoxazol-Vorstufen mit Diazochinonen, wie Diazonaphthochinonen, als photoaktive Komponente sind aus folgenden Druckschriften bekannt: EP-PS 0 023 662, EP-OS 0 291 779 und DE-OS 37 16 629.

Bei beiden der genannten Resisttypen können Schwierigkeiten auftreten, die durch die photoreaktiven Gruppen bzw. durch die photoaktive Komponente bedingt sind. Ungesättigte Gruppen neigen nämlich zur Polymerisation und bringen dadurch eine begrenzte Viskositätsstabilität von Resistlösungen mit sich. Diazochinone sind thermisch wenig stabil und können mit funktionellen Gruppen, beispielsweise Aminoendgruppen, reagieren, was sich ebenfalls auf die Lagerstabilität sowie auf die Reproduzierbarkeit des photolithographischen Prozesses ungünstig auswirkt. Außerdem verlangen die empfindlichen Photoresists bei der Verarbeitung - zum Ausschluß von Wellenlängen < 500 nm - mit Gelblicht ausgerüstete Räume.

Aufgabe der Erfindung ist es, ein Verfahren anzugeben, das eine einfache und kostengünstige Herstellung hochwärmebeständiger Reliefstrukturen aus Polybenzoxazol-Vorstufen erlaubt, ohne daß die bislang bei Positiv- bzw. Negativresists auf Polybenzoxazolbasis auftretenden Schwierigkeiten, insbesondere hinsichtlich Lagerstabilität und Reproduzierbarkeit, in Kauf genommen werden müssen.

Dies wird erfindungsgemäß dadurch erreicht, daß lösliche Hydroxypolyamide folgender Struktur 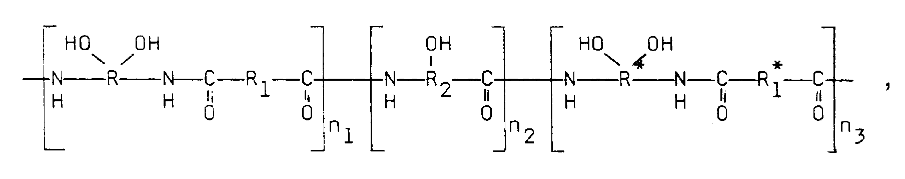 wobei R, R*, Rᵢ, R; und R₂ aromatische Gruppen sind und bezüglich n₁, n₂ und n₃ folgendes gilt:
n₁ = 1 bis 100, n₂ und n₃ = 0 oder
n₁ und n₂ = 1 bis 100, n₃ = 0 oder
n₂ = 1 bis 100, n₁ und n₃ = 0 oder
n₁, n₂ und n₃ = 1 bis 100 (mit R* und/oder R₁ R; ) oder
n, und n₃ = 1 bis 100, n₂ = 0 (mit R R* und/oder R₁ R; ), in Form einer Schicht oder Folie auf ein Substrat aufgebracht und mittels eines UV-Excimer-Lasers mit einer Leistungsdichte > 10⁵ W/cm² pro Puls durch eine Maske belichtet werden, und daß mit einem wäßrig-alkalischen Entwickler entwickelt und nachfolgend getempert wird.

Nach dem erfindungsgemäßen Verfahren lassen sich Polybenzoxazol-Vorstufen ohne das Vorhandensein von polymerisierbaren, d.h. ungesättigten Gruppen bzw. von photoaktiven Komponenten photostrukturieren, und zwar mit Hilfe eines Excimer-Lasers, dessen Emissionsbereich im UV liegt, beispielsweise ein XeCI-Laser. Mittels Laserbestrahlung (durch eine Maske) können somit erstmals unter alleiniger Verwendung von Vorstufen von hochwärmebeständigen Polymeren, d.h. ohne den Zusatz photoaktiver Komponenten bzw. ohne die Anwesenheit vernetzbarer Gruppen, auf photolithographischem Weg Reliefstrukturen erzeugt werden. Da keine photoaktiven Komponenten bzw. keine durch Licht vernetzenden Gruppen vorhanden sind, sind die beim erfindungsgemäßen Verfahren eingesetzten Polymer-Vorstufen und deren Lösungen sowie die daraus hergestellten Schichten oder Folien absolut unempfindlich gegen Licht, das beispielsweise aus der Umgebung oder von Lampen herrühren kann. Außerdem erfordern diese Polymer-Vorstufen - und somit auch das erfindungsgemäße Verfahren - keine Gelblichtausrüstung der Fertigungsräume.

Das erfindungsgemäße Verfahren bietet ferner den Vorteil, daß sich die Schichten und Folien aus den Polybenzoxazol-Vorstufen - in Abhängigkeit von der Laserleistung bzw. der Energiedichte - wahlweise als Positiv- oder Negativresist mit anschließender alkalischer Entwicklung strukturieren lassen. Außerdem können im Übergangsbereich zwischen Positiv- und Negativverhalten an der Grenze zwischen den belichteten und unbelichteten Bereichen feine Strukturen erzeugt werden.

Bei Polyamidocarbonsäuren sind durch Laserstrahlung induzierte Cyclisierungsreaktionen, d.h. Imidisierungsreaktionen, bekannt (siehe dazu: "Sov. J. Quantum Electron.", Vol. 4 (1975), Seiten 1287 und 1288, sowie "Sov. J. Quantum Electron.", Vol. 12 (1982), Seiten 1330 bis 1333). Hierbei handelt es sich allerdings um thermisch angeregte Vorgänge, sogenannte thermochemische Vorgänge; es wird nämlich mittels eines Gaslasers, d.h. eines C0₂-Lasers, im IR-Bereich gearbeitet (Pulsleistung:50 bis 100 W).

Die nach dem erfindungsgemäßen Verfahren hergestellten Reliefstrukturen sind konturenscharfund vergleichbar mit denjenigen Strukturen, die auf photolithographischem Weg unter Verwendung bekannter Photolacklösungen erhalten werden. Beim erfindungsgemäßen Verfahren wird außerdem die Schichtdicke in geringerem Ausmaß reduziert als dies bei der Erzeugung von Reliefstrukturen unter Einsatz von photoaktiven Komponenten der Fall ist. Im Vergleich zu Strukturen, die nach dem sogenannten Lochbrennen mittels Lasern erhalten werden, d.h. unmittelbar durch abtragende Bearbeitung von Werkstoffen, sind die nach dem erfindungsgemäßen Verfahren erzeugten Reliefstrukturen konturenschärfer und feiner. Darüber hinaus ist bei diesem Verfahren gewährleistet, daß auf dem Substrat keine Rückstände verbleiben, wie dies beim Lochbrennen infolge Verkohlung der Fall sein kann.

Wie bereits ausgeführt, zeigen beim erfindungsgemäßen Verfahren die Polymer-Vorstufen je nach Laserleistung und Energiedichte - ein Verhalten entsprechend demjenigen von Positiv- oder von Negativresists, d.h. aus den Polymerschichten lassen sich entweder positive oder negative Reliefstrukturen erzeugen. So bewirken eine hohe Energiedichte und Laserleistung ein Verhalten wie es bei Positivresists bekannt ist, d.h. die belichteten Bereiche sind im (alkalischen) Entwickler besser löslich als die unbelichteten Bereiche. Eine niedrige Energiedichte und Laserleistung führen dagegen zu einem Verhalten wie bei Negativresists, d.h. an den belichteten Stellen kommt es - im Vergleich zu den unbelichteten Stellen - zu einer verringerung der Löslichkeit im (alkalischen) Entwickler, und zwar aufgrund einer (partiellen) Cyclisierung. Bei einer mittleren Energiedichte und Laserleistung werden im Übergangsbereich zwischen Positiv- und Negativverhalten sowohl die belichteten als auch die unbelichteten Stellen im (alkalischen) Entwickler löslich, und nach der Entwicklung verbleiben an der Grenze zwischen diesen beiden Bereichen feine Linien bzw. Strukturen.

Im einzelnen gilt bei der Belichtung der Hydroxypolyamide folgendes:
- Positive Reliefbilder werden unter folgenden Bedingungen erhalten:
   Energiedosis: 3 bis 12 J/cm²;
   Energiedichte (pro Puls): 100 bis 150 mJ/cm²;
   Leistungsdichte (pro Puls): 2 bis 3.10⁶ W/cm².
- Negative Reliefbilder werden unter folgenden Bedingungen erhalten:
   Energiedosis: 4 bis 12 J/cm²;
   Energiedichte (pro Puls): 40 bis 60 mJ/cm²;
   Leistungsdichte (pro Puls): 8.10⁵ bis 1,2.10⁶ W/cm².
- Feine Strukturen im Bereich zwischen den belichteten und den unbelichteten Stellen werden unter folgenden Bedingungen erhalten:
   Energiedosis: ca. 4 J/cm²;
   Energiedichte (pro Puls): ca. 100 mJ/cm²;
   Leistungsdichte (pro Puls): 1,5 bis 2.10⁶ W/cm².

Die beim erfindungsgemäßen Verfahren eingesetzten Hydroxypolyamide weisen vorzugsweise aromatische Gruppen folgender Struktur auf. R und R* können folgende Bedeutung haben: 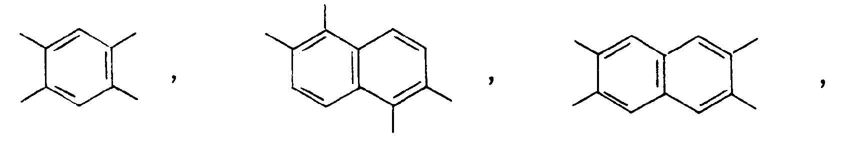 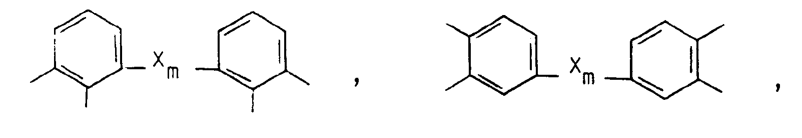 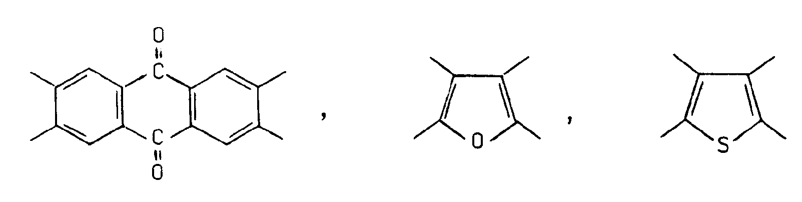 und 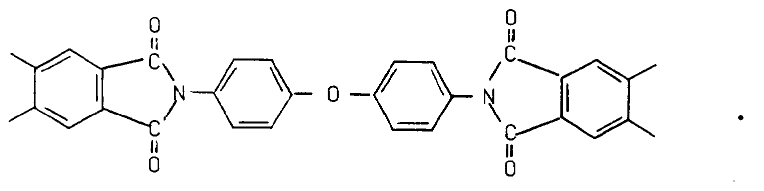
R₁ und R^{*}₁ können folgende Bedeutung haben, wobei H-Atome auch durch Cl oder Br substituiert sein können: 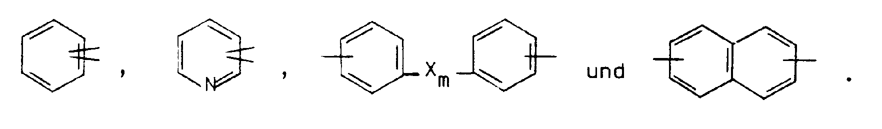
R₂ kann folgende Bedeutung haben:

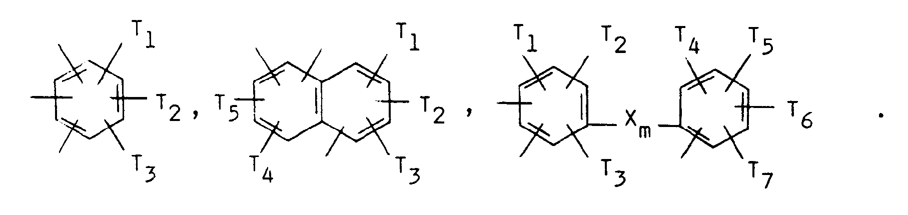

Dabei bedeuten T₁ bis T₇ H oder Alkyl, m = 0 oder 1, und x bedeutet:
-O-, CO, 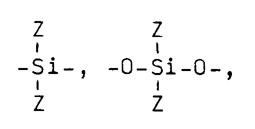
-S-, -SO₂- 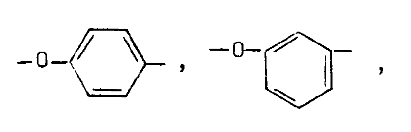 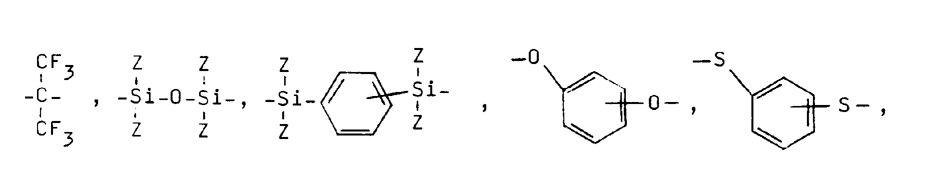 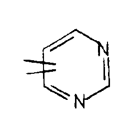
und -(CF₂)ᵣ- ;
dabei gilt folgendes:
Z = Alkyl mit 1 bis 10 Kohlenstoffatomen oder Aryl, und
r = 2 bis 18.

Die Polybenzoxazol-Vorstufen, d.h. die Hydroxypolyamide, werden beim erfindungsgemäßen Verfahren vorteilhaft als Lösung in einem organischen Lösungsmittel auf das Substrat aufgebracht. Als Lösungsmittel wird dabei vorzugsweise N-Methylpyrrolidon verwendet. Daneben können aber auch andere organische Lösungsmittel mit ähnlichen Eigenschaften zum Einsatz gelangen, wie Dimethylformamid und N.N-Dimethylacetamid, sowie Gemische der genannten Lösungsmittel.

Beim Verfahren nach der Erfindung kann vorteilhaft ein Haftvermittler und/oder ein Benetzungsmittel verwendetwerden. Haftvermittler bzw. Benetzungsmittel können dabei der Polymerlösung zugesetzt werden, sie können aber auch - vor der Beschichtung - auf das Substrat aufgebracht werden. Die Polymerlösung wird vorzugsweise mittels Schleudertechnik sowie Tauch- oder Sprühverfahren auf das Substrat aufgebracht. Daneben können aber auch andere Beschichtungsmethoden, wie Bürsten und Rollen, angewendet werden. Das Substrat besteht vorzugsweise aus Glas, aus Metall, insbesondere Aluminium, aus Kunststoff oder aus einem halbleitenden Material.

Die Umwandlung der strukturierten Polymerschichten in hochwärmebeständige Polybenzoxazole erfolgt durch einen Temperprozeß. Im allgemeinen werden dabei Temperaturen zwischen 200 und 500°C gewählt. Vorzugsweise erfolgt die Temperung bei einer Temperatur zwischen 300 und 450°C.

Anhand von Ausführungsbeispielen soll die Erfindung noch näher erläutert werden.

### Beispiel 1: Herstellung einer Polymerschicht

18 Masseteile einer Polybenzoxazol-Vorstufe, hergestellt aus 2.2-Bis(3-amino-4-hydroxyphenyl)-1.1.1.3.3.3-hexafluorpropan (50 Mol-%), 3.3'-Dihydroxybenzidin (50 Mol-%) und Isophthalsäuredichlorid (90 Mol-%) (siehe dazu: "Polym. Letters", Vol. 2 (1964), Seiten 655 ff.), werden in 45 Masseteilen N-Methylpyrrolidon gelöst und die Lösung wird dann durch ein 0,8 µm-Filter druckfiltriert. Anschließend wird die filtrierte Lösung im Spin-coating-Verfahren bei 2800 rpm/20 s auf einen mit einem Haftvermittler (0,5 %ige Lösung von N-(2-Aminoethyl)-3-aminopropyl-methyl-dimethoxysilan in Methanol/Wasser (95/5 v/v), nach 24stündigem Stehen bei 5000 rpm/30 s aufgebracht und bei 80°C für die Dauer von 10 min ausgeheizt) behandelten Aluminiumwafer aufgebracht und dann wird 12 min bei 90°C im Umluftofen getrocknet. Es wird eine Polymerschicht mit einer Dicke von 4,9 µm erhalten.

### Beispiel 2: Erzeugung negativer Strukturen

Eine nach Beispiel 1 hergestellte Polymerschicht wird mittels eines Excimer-Lasers (Wellenlänge: 308 nm) mit einer Energiedosis zwischen 4 und 12 J/cm² bei einer Energiedichte von 40 bis 60 mJ/cm² pro Puls und einer Leistungsdichte von 8.10⁵ bis 1,2.10⁶ W/cm² pro Puls durch eine Gittermaske (Löcher: 200 µm, Stege: 120 µm, Verkleinerung: 1:5) belichtet; der Schichtdickenverlust beträgt 0 bis 5 %. Nach dem Belichten wird das Substrat 90 s mit einem wäßrig-alkalischen Entwickler (NMD-3, 0,25 %ig) entwickelt (Schichtdickenverlust: ca. 10 %) und anschließend in einem Diffusionsofen unter Stickstoff getempert (Temperprogramm: Raumtemperatur bis 170°C: 1 h, 170 bis 300°C: 1 h, 300 bis 400°C: 1 h, 400°C: 1 h, 400°C bis Raumtemperatur: 4 h). Dabei entstehen kleine hochtemperaturstabile Tafeln mit einer Schichtdicke von 3,7 µm.

### Beispiel 3: Erzeugung positiver Strukturen

Eine nach Beispiel 1 hergestellte Polymerschicht wird mittels eines Excimer-Lasers (Wellenlänge: 308 nm) mit einer Energiedosis zwischen 3 und 12 J/cm² bei einer Energiedichte von 100 bis 150 mJ/cm² pro Puls und einer Leistungsdichte von 2 bis 3.10⁶ W/cm² pro Puls durch eine Gittermaske (Löcher: 200 µm, Stege: 120 µm, Verkleinerung: 1:5) belichtet; der Schichtdickenverlust an den belichteten Stellen beträgt zwischen 60 und 80 %. Nach dem Belichten wird das Substrat 90 s mit einem wäßrig-alkalischen Entwickler (NMD-3, 0,25 %ig) entwickelt (Schichtdickenverlust an den unbelichteten Stellen: 0 %) und anschließend in einem Diffusionsofen unter Stickstoff getempert (Temperprogramm: Raumtemperatur bis 170°C: 1 h, 170 bis 300°C: 1 h, 300 bis 400°C: 1 h, 400°C: 1 h, 400°C bis Raumtemperatur: 4 h). Dabei entsteht eine hochtemperaturstabile Gitterstruktur mit einer Schichtdicke von 3,7 µm.

### Beispiel 4: Erzeugung feiner Linien

Eine nach Beispiel 1 hergestellte Polymerschicht wird mittels eines Excimer-Lasers (Wellenlänge: 308 nm) mit einer Energiedosis von ca. 4 J/cm² bei einer Energiedichte von ca. 100 mJ/cm² pro Puls und einer Leistungsdichte von ca. 2.10⁶ W/cm² pro Puls durch eine Gittermaske (Löcher: 200 µm, Stege: 120 µm, Verkleinerung: 1:5) belichtet. Nach dem Belichten wird das Substrat 90 s mit einem wäßrig-alkalischen Entwickler (NMD-3, 0,25 %ig) entwickelt (Schichtdickenverlust an den unbelichteten Stellen: 0 %) und anschließend in einem Diffusionsofen unter Stickstoff getempert (Temperprogramm: Raumtemperatur bis 170°C: 1 h, 170 bis 300°C: 1 h, 300 bis 400°C: 1 h, 400°C: 1 h, 400°C bis Raumtemperatur: 4 h). Dabei entstehen im Grenzbereich zwischen den belichteten und unbelichteten Stellen feine Linien mit einer Schichtdicke von 3,7 µm.

## Patentansprüche

1. Verfahren zur Herstellung hochwärmebeständiger Reliefstrukturen aus oligomeren und/oder polymeren Polybenzoxazol-Vorstufen, dadurch gekennzeichnet, daß lösliche Hydroxypolyamide folgender Struktur 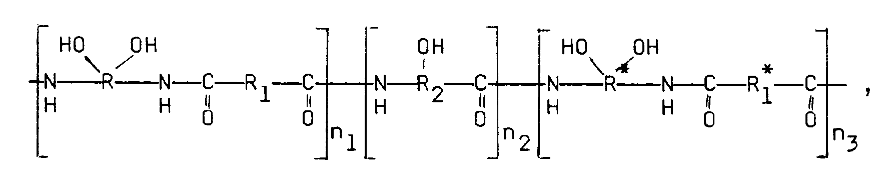 wobei R, R*, R₁, R; und R₂ aromatische Gruppen sind und bezüglich n₁, n₂ und n₃ folgendes gilt:
n₁ = 1 bis 100, n₂ und n₃ = 0 oder
n₁ und n₂ = 1 bis 100, n₃ = 0 oder
n₂ = 1 bis 100, n₁ und n₃ = 0 oder
n₁, n₂ und n₃ = 1 bis 100 (mit R R* und/oder R₁ R*₁) oder
n₁ und n₃ = 1 bis 100, n₂ = 0 (mit R R* und/oder R₁ R*₁),
in Form einer Schicht oder Folie auf ein Substrat aufgebracht und mittels eines UV-Excimer-Lasers mit einer Leistungsdichte > 10⁵ W/cm² pro Puls durch eine Maske belichtetwerden, und daß mit einem wäßrig-alkalischen Entwickler entwickelt und nachfolgend getempert wird.

2. Verfahren nach Anspruch 1 zur Herstellung eines negativen Reliefbildes, dadurch gekennzeichnet, daß mit einer Energiedosis von 4 bis 12 J/cm², einer Energiedichte pro Puls von 40 bis 60 mJ/cm² und einer Leistungsdichte pro Puls von 8.10⁵ bis 1,2.10⁶ W/cm² belichtet wird.

3. Verfahren nach Anspruch 1 zur Herstellung eines positiven Reliefbildes, dadurch gekennzeichnet, daß mit einer Energiedosis von 3 bis 12 J/cm², einer Energiedichte pro Puls von 100 bis 150 mJ/cm² und einer Leistungsdichte pro Puls von 2 bis 3.10⁶ W/cm² belichtet wird.

4. Verfahren nach Anspruch 1 zur Herstellung feiner Strukturen im Bereich zwischen den belichteten und unbelichteten Stellen, dadurch gekennzeichnet, daß mit einer Energiedosis von ca. 4 J/cm², einer Energiedichte pro Puls von ca. 100 mJ/cm² und einer Leistungsdichte pro Puls von 1,5 bis 2.10⁶ W/cm² belichtet wird.

5. Verfahren nach einem der Ansprüche 1 bis 4, dadurch gekennzeichnet, daß die Hydroxypolyamide als Lösung in einem organischen Lösungsmittel auf das Substrat aufgebracht werden.

6. Verfahren nach Anspruch 5, dadurch gekennzeichnet, daß als Lösungsmittel N-Methylpyrrolidon verwendet wird.

7. Verfahren nach einem oder mehreren der Ansprüche 1 bis 6, dadurch gekennzeichnet, daß ein Haftvermittler und/oder ein Benetzungsmittel verwendet wird.

8. Verfahren nach einem oder mehreren der Ansprüche 1 bis 7, dadurch gekennzeichnet, daß bei einer Temperatur zwischen 200 und 500°C, vorzugsweise zwischen 300 und 450°C, getempert wird.

## Claims

1. Method for the production of highly heat- resistant relief structures from oligomeric and/or polymeric polybenzoxazole precursors, characterized in that soluble hydroxypolyamides of the following structure 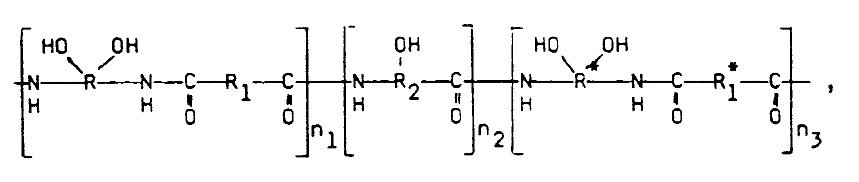 whereby R, R*, R_{1'} R; and R₂ are aromatic groups and with regard to n₁, n₂ and n₃ the following applies:
n₁ = 1 to 100, n₂ and n₃ = 0 or
n₁ and n₂ = 1 to 100, n₃ = 0 or
n₂ = 1 to 100, n₁ and n₃ = 0 or
n₁, n₂ and n₃ = 1 to 100 (with R + R* and/or R₁ R;) or
n₁ and n₃ = 1 to 100, n₂ = 0 (with R + R* and/or R₁ R^{*}₁),
are applied in the form of a layer or a film to a substrate and by means of a UV excimer laser are exposed with a power density > 10⁵ W/cm² per pulse through a mask, and in that development takes place with an aqueous-alkaline developing agent and subsequently tempering takes place.

2. Method according to claim 1 to produce a negative relief image, characterized in that exposure takes place with an energy dose of 4 to 12 J/cm², an energy density per pulse of 40 to 60 mJ/cm² and a power density per pulse of 8 x 10⁵ to 1.2 x 10⁶ W/cm².

3. Method according to claim 1 to produce a positive relief image, characterized in that exposure takes place with an energy dose of 3 to 12 J/cm², an energy density per pulse of 100 to 150 mJ/cm² and a power density per pulse of 2 to 3 x 10⁶ W/cm².

4. Method according to claim 1 to produce fine structures in the region between the exposed and the unexposed points, characterized in that exposure takes place with an energy dose of about 4 J/cm², an energy density per pulse of about 100 mJ/cm² and a power density per pulse of 1.5 to 2 x 10⁶ W/cm².

5. Method according to one of claims 1 to 4, characterized in that the hydroxypolyamides are applied to the substrate as a solution in an organic solvent.

6. Method according to claim 5, characterized in that N-methyl pyrrolidone is used as solvent.

7. Method according to one or more of claims 1 to 6, characterized in that an adhesive agent and/or a wetting agent is used.

8. Method according to one or more of claims 1 to 7, characterized in that tempering takes place at a temperature between 200 and 500°C, preferably between 300 and 450°C.

## Revendications

1. Procédé de fabrication de structures en relief, très stables à la chaleur à partir de précurseurs polyben- zoxazoles oligomères et/ou polymères, caractérisé en ce que des hydroxypolyamides solubles de la structure suivante 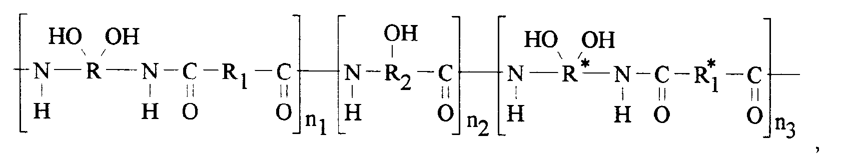 dans laquelle R, R*, R_{1'} R*₁ et R₂ représentent des groupes aromatiques et où vaut ce qui suit concernant n₁, n₂ et n₃ :
ni = 1 à 100, n₂ et n₃ = 0 ou
ni et n₂ = 1 à 100, n₃ = 0 ou
n₂ = 1 à 100, ni et n₃ = 0 ou
nₗ, n₂ et n₃ = 1 à 100 (avec R ≠ R* et/ou R₁ ≠ R*₁) ou
ni et n₃ = 1 à 100, n₂ = 0 (avec R ≠ R* et/ou R₁ ≠ R*ᵢ),
sont appliquées sous forme d'une couche ou d'une feuille sur un substrat et qu'elles sont exposées à travers un masque grâce à un laserexcimerà U.V. avec une puissance volumique > 10⁵ W/cm² par impulsion, et que l'on développe avec un révélateur basique aqueux et que l'on durcit ensuite par trempe.

2. Procédé selon la revendication 1 pour la fabrication d'une image en relief négatif, caractérisé en ce qu'on expose avec une dose d'énergie de 4 à 12 J/cm², avec une densité d'énergie par impulsion de 40 à 60 mJ/cm² et avec une puissance volumique par impulsion de 8.10⁵ à 1,2.10⁶ W/cm².

3. Procédé selon la revendication 1 pour la fabrication d'une image en relief positif, caractérisé en ce qu'on expose avec une dose d'énergie de 3 à 12 J/cm², avec une densité d'énergie par impulsion de 100 à 150 mJ/cm² et avec une puissance volumique par impulsion de 2 à 3.10⁶ W/cm².

4. Procédé selon la revendication 1 pour la fabrication de structures fines dans la région entre les endroits exposés et non-exposés, caractérisé en ce que l'on expose avec une dose d'énergie d'environ 4 J/cm², avec une densité d'énergie par impulsion d'environ 100 mJ/cm² et avec une puissance volumique par impulsion de 1,5 à 2.10⁶ W/cm².

5. Procédé selon l'une quelconque des revendications 1 à 4, caractérisé en ce que les hydroxypolyamides sont appliquées sur le substrat sous forme de solution dans un solvant organique.

6. Procédé selon la revendication 5, caractérisé en ce qu'on utilise comme solvant la N-méthylpyrrolidone.

7. Procédé selon une ou plusieurs des revendications 1 à 6, caractérisé en ce qu'on utilise un agent d'adhérence et/ou un agent mouillant.

8. Procédé selon une ou plusieurs des revendications 1 à 7, caractérisé en ce qu'on durcit par trempe à une température entre 200 et 500°C, de préférence entre 300 et 450 °C.
